(19) Europäisches Patentamt

European Patent Office

Office européen des brevets

(11) Publication number: **0 242 005 B1**

# EUROPEAN PATENT SPECIFICATION

(45) Date of publication of patent specification: **23.10.91**  (51) Int. Cl.⁵: **H05K 7/20**

(21) Application number: **87200708.3**

(22) Date of filing: **15.04.87**

(54) **Electronics module mounting assembly.**

(43) Date of publication of application:
**21.10.87 Bulletin 87/43**

(45) Publication of the grant of the patent:
**23.10.91 Bulletin 91/43**

(84) Designated Contracting States:
**DE ES FR IT NL SE**

(56) References cited:
**DE-A- 3 147 790**
**GB-A- 2 102 209**
**US-A- 4 298 904**
**US-A- 4 318 157**
**US-A- 4 354 770**

(73) Proprietor: **GEC-MARCONI LIMITED**
**The Grove, Warren Lane**
**Stanmore, Middlesex HA7 4LY(GB)**

(72) Inventor: **Hales, Arthur Charles George**
**3 North Street**
**Bedhampton Hants,P09 3HD(GB)**

(74) Representative: **Waters, Jeffrey**
**GEC Patent Department (Chelmsford Office)**
**GEC-Marconi Research Centre, West Hanningfield Road**
**Great Baddow, Chelmsford, Essex CM2 8HN(GB)**

## Description

This invention relates to a mounting assembly for electronics modules and more especially it relates to an assembly which facilitates the mounting of modules such as ceramic tiles carrying electronics components in stacked fashion one above the other within a rack.

Rack stacking arrangements for electronics components such as printed circuit boards or the like are well known.

One of the problems with such arrangements however is that due to the high density of the component packing, heat dissipation may become a problem. In order to minimise this problem, electronics modules are mounted on heat sinks and the heat sinks are supported in a rack such that the heat is conducted away through housing walls which are slotted to define the rack.

It has been proposed in US-A-4,345,770 to provide an electronics module mounting assembly comprising a rigid heat sink plate for supporting an electronics module, the heat sink plate being located between two parallel ribs which are in use received into juxtaposed slots in a mounting rack and secured in that position by means of a wedge and anvil arrangement. Such an electronics module mounting assembly can be made simple and inexpensive to fabricate and in use facilitates efficient conduction of heat away from the assembly via the walls of a rack in which the assembly is supported.

According to the invention, each rib is formed integrally with the heat sink plate, each rib comprising an elongate channel section adapted at each end to define a ramp, the open sides of each channel section being narrowed thereby to form a neck portion which serves to retain within the channel section an elongate member, which at one end is secured to a first clamp member and which at the other end is screw threaded to receive a nut which is arranged to bear against a second clamp member, such that when the nut is tightenend the clamp members at opposite ends of each channel section are constrained to move toward each other up the ramps, whereby in use the assembly is clamped within opposite slots of a mounting rack by means of the clamp members which serve to maintain the ribs in intimate contact with the walls of the slot and thereby facilitate heat transfer from the ribs to the rack by conduction.

The first clamp member may comprise a short bar of circular cross-section secured to the elongate member transversely so that its circular periphery makes contact with the ramp along a line parallel to that axis of the bar which is coaxial with the circular periphery.

The second clamp member may comprise a bar of part circular cross-section the circular portion of which is arranged in contact with an adjacent ramp and a flat portion of which is arranged to co-operate with the nut.

The heat sink plate and ribs may be constructed of aluminium or an aluminium alloy and formed integrally by means of an extrusion process for example. The nut, the clamp members or the elongate member may be constructed of stainless steel.

The mounting assembly may comprise a ceramic tile module secured to and supported by the heat sink plate.

One embodiment of the invention will now be described by way of example with reference to the accompanying drawing in which:

Figure 1 is a plan view of a ribbed heat sink plate which forms a principal part of an electronics module mounting assembly;

Figure 2 is a side view of a part of the heat sink plate and ribs shown in Figure 1;

Figure 3 is a sectional view of a rib shown in Figure 1; and,

Figure 4 is a perspective view of a mounting assembly for an electronics module.

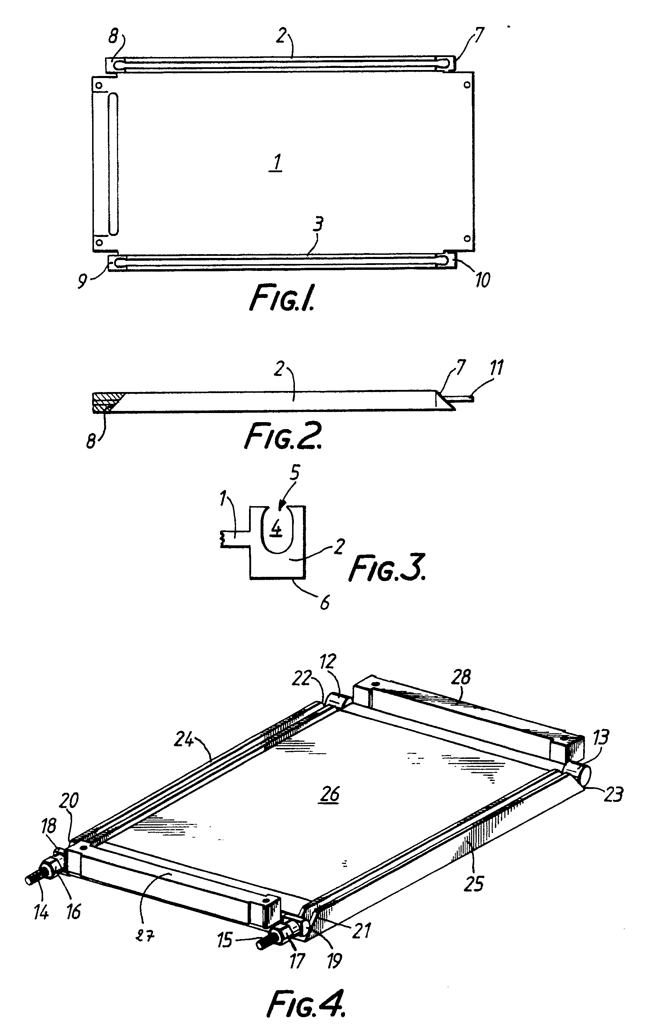

Referring now to Figure 1 a mounting assembly for an electronics module comprises a heat sink plate 1 which is formed integrally between a pair of ribs 2 and 3. an enlarged sectional view of the rib 2 is shown in Figure 3 and it comprises a channel 4 having a narrow neck portion 5, the heat sink plate 1 being arranged to extend orthogonally of the rib intermediate between the narrow neck portion 5 and a clamping surface 6.

As shown in Figure 2 each rib is machined to form ramps 7 and 8 at each end of the rib 2 and ramps 9 and 10 at each end of the rib 3. Also as shown in Figure 2, an elongate member or stud 11 which is threaded at each end is located within the channel section of the ribs 2 and 3 and retained therein by means of the narrow neck portion 5 as shown in Figure 3.

As shown in Figure 4, first clamp members 12 and 13 are secured at one end of studs 14 and 15 respectively and nuts 16 and 17 are fitted to the other ends of the studs 14 and 15 so as to urge further clamping members 18 and 19 against ramps 20 and 21. Thus as the nuts 16 and 17 are tightened on the studs 14 and 15, the clamping members 18 and 19 tend to advance up the ramps 20 and 21. Similarly the clamping members 12 and 13 are constrained to advance up ramps 22 and 23 at ends of ribs 24 and 25 remote from the nuts 16 and 17.

Thus it will be appreciated that when fitted within a rack slot surfaces of the ribs corresponding to the clamping surface 6 will be urged into intimate engagement with one wall of the slot, as the clamps such as members 12, 13, 18 and 19 are urged against the opposing slot wall.

In the present example as shown in Figure 4 a heat sink plate 26 formed integrally with the ribs 24 and 25 is used to support a ceramic tile module on which electronics components are mounted. In order to make electrical contact with the electronics components, connector sockets 27 and 28 (shown schematically) are provided.

In order to facilitate integral fabrication of the heat sink plate and the ribs by extrusion, the heat sink plate and the ribs are conveniently fabricated from aluminium or an aluminium alloy. The nuts, clamps and studs on the other hand are fabricated from stainless steel. Since the heating plate and the ribs are fabricated as one extrusion they are particularly rigid and little finishing cost is incurred. The clamps 12 and 13 are fabricated from rod material which is inexpensive to provide and the clamps 18 and 19 are fabricated from similar material with minimal machining. It will be appreciated that installation is facilitated since the clamps have no projecting sharp edges. Since the clamps are disposed approximately centrally they have no chance of rotating out of alignment whereby installation would be prevented. By using dissimilar materials for the construction of the clamps and the ramps the occurrence of pressure welded joins is obviated.

Various modifications may be made to the arrangements just before described without departing from the scope of the invention as defined in the appended claims and for example nut and clamp arrangements of slightly different shape may be used.

## Claims

1. An electronics module mounting assembly comprising a rigid heat sink plate (26) for supporting an electronics module, the heat sink plate (26) being located between two parallel ribs (24, 25), which are in use received into juxtaposed slots in a mounting rack, characterised in that each rib (24, 25) is formed integrally with the heat sink plate (26), each rib (24, 25) comprising an elongate channel section (4) adapted at each end to define a ramp (20, 22, 21, 23), the open sides of each channel section being narrowed thereby to form a neck portion (5) which serves to retain within the channel section (24, 25) an elongate member (14,15), which at one end is secured to a first clamp member (12, 13) and which at the other end is screw threaded to receive a nut (16, 17) which is arranged to bear against a second clamp member (18, 19), such that when the nut (16, 17) is tightened the clamp members (12, 18, 13, 19) at opposite ends of each channel section (24, 25) are constrained to move toward each other up the ramps (22, 20, 23, 21), whereby in use the assembly is clamped within opposite slots of the mounting rack by means of the clamp members which serve to maintain the ribs in intimate contact with the walls of the slot and thereby facilitate heat transfer from the ribs to the rack by conduction.

2. An electronics module mounting assembly as claimed in claim 1, in which the first clamp member comprises a short bar of circular cross-section secured to the elongate member transversely so that its circular periphery makes contact with the ramp along a line parallel to that axis of the bar which is coaxial with the circular periphery.

3. An electronics module mounting assembly as claimed in claim 1 or 2, in which the second clamp member comprises a bar of part circular cross-section the circular portion of which is arranged in contact with an adjacent ramp and a flat portion of which is arranged to cooperate with the nut.

4. An electronics module mounting assembly as claimed in any one of claims 1 to 3, in which the heat sink plate and ribs are constructed of aluminium or an aluminium alloy and formed integrally by means of an extrusion process.

5. An electronics module mounting assembly as claimed in any one of claims 1 to 4, in which the nut, the clamp members or the elongate member are constructed of stainless steel.

6. An electronics module mounting assembly as claimed in any one of claims 1 to 5, the assembly comprising a ceramic tile module secured to and being supported by the heat sink plate.

## Revendications

1. Ensemble de montage de modules électroniques, comprenant une plaque rigide (26) de radiateur destinée à supporter un module électronique, la plaque de radiateur (26) étant placée entre deux nervures parallèles (24, 25) qui, pendant l'utilisation se logent dans des fentes juxtaposées formées dans un râtelier de montage, caractérisé en ce que chaque nervure (24, 25) est formée en une seule pièce avec la plaque de radiateur (26), chaque nervure (24, 25) comprenant un tronçon allongé (4) en forme de canal destiné à délimiter une rampe (20, 22, 21, 23) à chaque extrémité, les côtés ouverts de chaque tronçon de canal étant rétrécis et formant une partie (5) de col qui est destinée à retenir, dans le tronçon de canal (24, 25), un organe allongé (14, 15) qui est fixé, à une première extrémité, à un premier organe de serrage (12, 13) et qui, à l'autre extrémité, est fileté pour coopérer avec un écrou (16, 17) qui est destiné à être en appui contre un second organe de serrage (18, 19), si bien que, lorsque l'écrou (16, 17) est serré, les organes de serrage (12, 18, 13, 19) des extrémités opposées de chaque tronçon de canal (24, 25) sont obligés de se rapprocher en remontant le long des rampes (22, 20, 23, 21), si bien que, pendant l'utilisation, l'ensemble est serré dans les lentes opposées du râtelier de montage par les organes de serrage dont le rôle est de maintenir les nervures en contact intime avec les parois de la lente et de faciliter ainsi le transfert de chaleur des nervures au râtelier par conduction.

2. Ensemble de montage de modules électroniques selon la revendication 1, dans lequel le premier organe de serrage comporte une courte barre de section circulaire, fixée à l'organe allongé transversalement afin que sa périphérie circulaire soit au contact de la rampe le long d'un axe parallèle à l'axe de la barre qui est coaxial à la périphérie circulaire.

3. Ensemble de montage de modules électroniques selon la revendication 1 ou 2, dans lequel le second organe de serrage comporte une barre de section partiellement circulaire, dont la partie circulaire est destinée à être au contact d'une rampe adjacente et dont une partie plate est destinée à coopérer avec l'écrou.

4. Ensemble de montage de modules électroniques selon l'une quelconque des revendications 1 à 3, dans lequel la plaque de radiateur et les nervures sont formées d'aluminium ou d'un alliage d'aluminium et sont formées en une seule pièce par une opération d'extrusion.

5. Ensemble de montage de modules électroniques selon l'une quelconque des revendications 1 à 4, dans lequel l'écrou, les organes de serrage ou l'organe allongé sont formés d'acier inoxydable.

6. Ensemble de montage de modules électroniques selon l'une quelconque des revendications 1 à 5, l'ensemble comprenant un module à support céramique fixé à la plaque de radiateur et supporté par celle-ci.

**Patentansprüche**

1. Elektronikmodul-Befestigungsanordnung, die umfaßt eine starre Wärmesenkeplatte (26) zum Halten eines Elektronikmoduls, wobei die Wärmesenkeplatte (26) zwischen zwei parallelen Rippen (24, 25) angeordnet ist, die im Gebrauch in zwei gegenüberliegenden Schlitzen in einem Befestigungsgestell aufgenommen sind, dadurch gekennzeichnet, daß jede Rippe (24, 25) integral mit der Wärmesenkeplatte (26) ausgebildet ist, wobei jede Rippe (24, 25) einen länglichen U-Profilabschnitt (4) umfaßt, der an jedem Ende zum Bestimmen einer schräg ansteigenden Rampe (20, 22, 21, 23) ausgebildet ist, wobei die offenen Seiten jedes U-Profilabschnitts verengt sind, um dadurch einen Halsabschnitt (5) zu bilden, der zum Zurückhalten eines länglichen Gliedes (14, 15) innerhalb des U-Profilabschnitts (24, 25) dient, das an einem Ende an einem ersten Klemmglied (12, 13) befestigt ist und am anderen Ende mit einem Schraubengewinde versehen zum Aufnehmen einer Mutter (16, 17), die gegen ein zweites Klemmglied (18, 19) anliegend angeordnet ist, so daß beim Anziehen der Mutter (16, 17) die Klemmglieder (12, 18, 13, 19) an entgegengesetzt liegenden Enden jedes U-Profilabschnitts (24, 25) bei einer Bewegung aufeinander zu gezwungen sind, sich die Rampen (22, 20, 23, 21) hinauf zu bewegen, wodurch im Gebrauch die Anordnung innerhalb der einander gegenüberliegenden Schlitze des Befestigungsgestells mittels der Klemmglieder geklemmt sind, welche dazu dienen, die Rippen in inniger Berührung mit den Wänden des Schlitzes zu halten und dadurch Wärmeübertragung von den Rippen auf das Gestell durch Leitung zu ermöglichen.

2. Elektronikmodul-Befestigungsanordnung nach Anspruch 1, bei der das erste Klemmglied einen kurzen Stab von kreisförmigem Querschnitt umfaßt, der an dem länglichen Glied quer befestigt ist, so daß sein Kreisumfang mit der Rampe längs einer zu der zu dem Kreisumfang koaxialen Achse des Stabes parallelen Linie Kontakt herstellt.

3. Elektronikmodul-Befestigungsanordnung nach Anspruch 1 oder 2, bei der das zweite Klemmglied einen Stab mit einem teilweise kreisförmigen Querschnitt umfaßt, von dem der kreisförmige Abschnitt in Kontakt mit einer benachbarten Rampe angeordnet ist, und ein flacher Abschnitt zum Zusammenwirken mit der Mutter angeordnet ist.

4. Elektronikmodul-Befestigungsanordnung nach einem der Ansprüche 1 bis 3, bei der die Wärmesenkeplatte und die Rippen aus Aluminium oder einer Aluminiumlegierung bestehen und integral mittels eines Extrusionsvorgangs ausgebildet sind.

5. Elektronikmodul-Befestigungsanordnung nach einem der Ansprüche 1 bis 4, bei dem die Mutter, die Klemmglieder oder das längliche Glied aus rostfreiem Edelstahl aufgebaut sind.

6. Elektronikmodul-Befestigungsanordnung nach einem der Ansprüche 1 bis 5, wobei die Anordnung einen an der Wärmesenkeplatte befestigten und von ihr abgestützten Keramik-Fliesenmodul umfaßt.

FIG.I.

FIG.2.

FIG.3.

FIG.4.